# EUROPÄISCHE PATENTSCHRIFT

(11) **EP 0 667 060 B1**
(45) Veröffentlichungstag und Bekanntmachung des Hinweises auf die Patenterteilung: **28.05.1997**
(21) Anmeldenummer: 93924009.9
(22) Anmeldetag: 29.10.1993
(51) Int. Cl.: H03K 19/23, H03K 19/14, G06G 7/00, H01L 45/00

(54) **ELEKTRONISCHES BAUELEMENT**
ELECTRONIC COMPONENT
COMPOSANT ELECTRONIQUE

(30) Priorität: 29.10.1992 DE 4236644
(43) Veröffentlichungstag der Anmeldung: 16.08.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: BAUER, Norbert, D-91058 Erlangen (DE); BÖBEL, Friedrich, D-91080 Uttenreuth (DE); HAKEN, Hermann, D-70569 Stuttgart (DE)
(74) Vertreter: Münich, Wilhelm, Dr.
(86) Internationale Anmeldenummer: DE9301039
(87) Internationale Veröffentlichungsnummer: WO9410755

(56) Entgegenhaltungen:
- EP-A- 0 266 811
- EP-A- 0 273 306
- US-A- 5 093 803
- APPLIED PHYSICS LETTERS, Band 59, Nr. 10, 2. September 1991, Woodbury, NY M.S. MAZZOLA et al. "Analysis of nonohmic current-voltage characteristics in a Cu-com- pensated GaAs photoconductor" Seiten 1182-1184,
- H. HAKEN "Synergetic Com- puters and Cognition" 1991, Berlin Seiten 56-59, Seiten 56-59 (in der Beschreibung genannt).

## Beschreibung

### Technisches Gebiet

Die Erfindung bezieht sich auf ein elektronisches Bauelement.

### Stand der Technik

Bei vielen Methoden in der Bildverarbeitung, z.B. bei morphologischen Methoden wie Erosions- und Dilatationsfilterungen, bei der Normierung von Bildern, bei der Musterwiedererkennung, Mustervervollständigung sowie bei der Klassifikation spielt das Konzept "the winner take it all" eine entscheidende Rolle. Hiermit ist gemeint, daß aus einer Anzahl numerischer Werte der jeweils größte Wert herausgenommen wird. Bei den numerischen Werten kann es sich dabei um bereits vorverarbeitete und/oder reduzierte Daten handeln, wie es bei einer Klassifikation meistens der Fall ist, oder um Rohdaten, wie sie bei der Filterung von Originalbildern vorliegen.

Auch bei der Verwendung neuerer Signal- und Bildverarbeitungsmethoden, z.B. mit Hilfe neuronaler Netze ist "the winner take it all" ein wichtiges Konzept. So wird am Ausgang eines Backpropagation-Netzes die Entscheidung nach dem Neuron mit dem größten Wert getroffen.

Das Prinzip "the winner take it all" ist auch das entscheidende Funktionsprinzip von synergetischen Computern:

Das Konzept des synergetischen Computers wurde von H. Haken und Mitarbeitern (H. Haken, Synergetic Computers and Cognition, Springer Verlag, Berlin, 1991) entwickelt und zeichnet sich durch eine sehr hohe Leistungsfähigkeit auf den Gebieten Mustererkennung, Mustervervollständigung und Klassifikation aus. Darüberhinaus eignet es sich zum überwachten und unüberwachten Lernen.

Ein synergetische Computer besteht im wesentlichen aus zwei Modulen.

Im ersten Modul werden die Rohdaten vorverarbeitet, z.B. werden Bilddaten translations-, rotations- und skalierungsinvariant aufbereitet, und durch Vergleich mit gespeicherten Prototypen sogenannten Ordnungsparametern zugeordnet.

Das zweite Modul unterzieht die Ordnungsparameter einer Entscheidungs- oder Verdrängungsdynamik, wobei sich der anfänglich stärkste Ordnungsparameter durchsetzt, d.h. gegen 1 konvergiert, wohingegen alle anderen Ordnungsparameter zu 0 werden. Auch hier gilt also das Prinzip "the winner take it all".

Ein Bauelement, das aus vielen parallel anliegenden Eingangssignalen, die insbesondere Ordnungsparameter repräsentieren können, möglichst schnell den größten Wert herausfiltert, wäre ein für einen synergetischen Computer, aber auch für die anderen, eingangs genannten Verfahren, die das Prinzip "the winner take ist all" verwenden, sehr wertvolles Bauelement. Ein Bauelement, das hardwaremäßig diese Entscheidungsprinzipien realisiert, ist jedoch bislang nicht bekannt.

### Darstellung der Erfindung

Der Erfindung liegt die Aufgabe zugrunde, ein Bauelement anzugeben, das hardwaremäßig aus einer Reihe von parallel anliegenden Eingangssignalen das Eingangssignal mit dem anfänglich größten Wert herausfiltert, wobei die zu allen anderen Eingangssignalen gehörenden Ausgangssignale zu Null werden.

Eine erfindungsgemäße Lösung dieser Aufgabe ist im Patentanspruch 1 angegeben, Weiterbildungen der Erfindung sind Gegenstand der Ansprüche 2 f..

Das erfindungsgemäße Bauelement weist einen Bauelement-Körper mit N Eingangsanschlüssen, die mit (bis zu) N Eingangssignalen beaufschlagbar sind, und M Ausgangsanschlüssen auf, von denen jeder einem oder mehreren Eingangsanschlüssen zugeordnet ist. In dem Bauelement-Körper bauen sich zunächst in Abhängigkeit von den Eingangssignalen Strompfade bzw. -filamente auf, die die N Eingangsanschlüsse mit den M Ausgangsanschlüssen verbinden.

Zur Realisierung einer Entscheidungs- bzw. Verdrängungsdynamik ist dem aus einem Halbleiter aufgebauten Bauelement ein Vorwiderstand vorgeschaltet, der in Abhängigkeit einer äußeren angelegten Größe den Stromfluß durch den Bauelement-Körper zwischen der anfänglichen Verteilung, bei der die Stromdichten (jᵢ) zwischen jedem Eingangsanschluß und dem zugeordneten Ausgangsanschluß dem den jeweiligen Eingangsanschluß beaufschlagenden Eingangssignal entsprechen, und einer selbstorganisierenden Verteilung umschaltet, bei der Strom nur noch zwischen dem Eingangsanschluß, der mit dem Eingangssignal mit dem größten Wert beaufschlagt ist, und dem zugeordneten Ausgangsanschluß (-schlüssen) fließt.

Erfindungsgemäß wird damit ein Bauelement geschaffen, das beispielsweise zur Realisierung eines synergetischen Computers eingesetzt werden kann, da es selber nach synergetischen, d.h. selbstorganisierenden Prinzipien arbeitet. Dieses Bauelement wird im folgenden deshalb auch als Synistor bezeichnet.

Die an das Bauelement angelegte äußere Größe kann gemäß Anspruch 2 insbesondere eine Betriebsspannung sein, die zur Einstellung der anfänglichen Verteilung direkt an den Bauelement-Körper und zur Einstellung der selbstorganisierten Verteilung über eine Schaltung, die einen geringeren Spannungsabfall über dem Halbleiterelement bewirkt, wie z.B. einen regelbaren Vorwiderstand an den Bauelement-Körper angelegt wird. Selbstverständlich können zum Umschalten aber auch andere Größen, wie Magnetfelder, elektrische Felder etc. verwendet werden.

Erfindungsgemäß wird zur Realisierung eines derartigen Synistors ein physikalischer Effekt verwendet, der bei dotierten Halbleitern beobachtet wird, deren Ladungstransport hauptsächlich durch Stoßionisation verursacht wird. Exemplarisch wird zu diesem physikalischen Effekt auf "Appl. Phys. Lett. 59 (10), 1991, S. 1182 bis 1184 verwiesen. Ausdrücklich soll jedoch festgehalten werden, daß über die in diesem Artikel genannten Materialien weitere geeignete Materialien existieren.

In Falle dieses physikalischen Effekts, bei dessen Auftreten Ladungstransport im wesentlichen durch Stoßionisation hervorgerufen wird, lassen sich nämlich Betriebsarten finden, bei denen der Strom nicht durch den gesamten Halbleiterkristall fließt; vielmehr bilden sich Bereiche aus, in denen die Stromdichte j relativ groß ist, sowie Bereiche, für die j = 0 gilt. Durch das Zuschalten beispielsweise eines geeigneten Vorwiderstandes tritt Konkurrenz zwischen den einzelnen Stromfilamenten auf.

Erfindungsgemäß ist erkannt worden, daß die daraufhin ablaufende Entscheidungsdynamik den Gesetzen der Synergetik folgt und somit zur Realisierung eines synergetischen Computers eingesetzt werden kann. Es wird sich also das anfänglich stärkste Element durchsetzen; dies bedeutet, daß, nachdem die Entscheidungsdynamik konvergiert ist, der gesamte Strom durch ein einziges Filament fließt, während in allen anderen Bereichen des Halbleiters kein Stromfluß auftritt. Diesen Effekt kann man auch als Entscheidung, Klassifikation, Filterung etc. auffassen. Wie bereits vorstehend erwähnt, wählt der Synistor aus einer Anzahl von Werten den größten heraus. Diese Werte können einzelne Pixel sein oder z.B. Korrelationen zwischen einem Eingangsbild und verschiedenen gespeicherten Bildern (sogenannten Prototypen).

Damit der Synistor als Klassifikator arbeitet, ist in den meisten Fällen eine Vorverarbeitung im Sinne der synergetischen Computertheorie notwendig, die aus Rohdaten (z.B. einem Eingangsbild) durch Vergleich mit gespeicherter Information (z.B. Prototypen) sogenannte Ordnungsparameter gewinnt. Der Synistor sucht dann den größten Ordnungsparameter heraus ("the winner take it all").

Das Eingangsbild wird dann dem Prototyp zugeordnet, der dem übriggebliebenen Stromfilament zugehört und somit klassifiziert. Im Falle von Erosions-/Dilatationsfiltern ist keine Vorverarbeitung notwendig, da Minimum- und Maximumoperationen direkt auf den Bilddaten ausgeführt werden.

Allgemein gehören alle Vorverarbeitungsschritte, die eine Transformation von Rohdaten zu Ordnungsparametern ausführen, zum ersten Modul des synergetischen Computers. Der Synistor braucht als Eingangsgrößen bereits Ordnungsparameter, die nur in Ausnahmefällen direkt aus den Rohdaten zur Verfügung stehen.

Die Möglichkeit auf synergetische Mechanismen zurückzugreifen, eröffnet völlig neue Wege in der Schaltungsentwicklung:

Beispielsweise kann ein Synistor innerhalb weniger 10 Nanosekunden tausende von Ordnungsparametern miteinander vergleichen und so eine Entscheidung in einer Zeit treffen, die etwa 10³ bis 10⁵ mal kürzer ist als bei der gegenwärtig neuesten Generation von Hochleistungscomputern oder Bildverarbeitungshardware.

Das erfindungsgemäß geschaffene Bauelement zeichnet sich durch folgende Leistungsmerkmale aus:
- Hohe potentielle Integrationsdichte:
   Die theoretische Grenze für die Filamentdichte liegt bei ca. 10¹⁰ Filamenten pro cm². Der Geschwindigkeitsvorteil gegenüber herkömmlichen elektronischen Bauelementen steigt linear mit der Integrationsdichte.
- Einfache Herstellungsweise:
   Ein Synistor besteht im wesentlichen aus einer dünnen Lage Halbleitermaterial, das für Stoßionisation günstig dotiert ist. Komplexere Herstellungsverfahren werden lediglich beim Einkoppeln der Anfangszustände (z.B. über Licht) oder beim Ankoppeln der Zuleitungen benötigt.
- Hohe Rechengeschwindigkeit:
   Die für das Ablaufen der Entscheidungsdynamik notwendige Zeit beträgt typisch einige 10 ns bis 100 ns.

### Kurze Beschreibung der Zeichnung

Die Erfindung wird nachstehend anhand von Ausführungsbeispielen unter Bezugnahme auf die Zeichnung näher beschrieben, in der zeigen:
- Fig. 1: die Bandlücke eines Halbleiters, und
- Fig. 2: die geometrischen Abmessungen und die Ausprägung von Stromfilamenten.

### Beschreibung von Ausführungsbeispielen

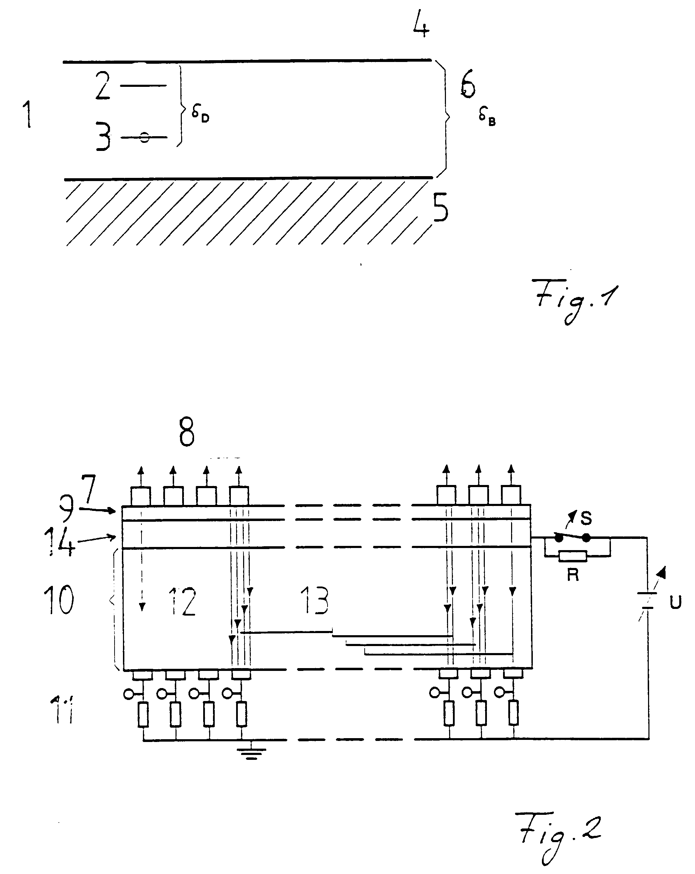

Ein Synistor basiert auf selbstorganisierenden Mechanismen, wie sie beim Ladungstransport durch Stoßionisation in Halbleitern auftreten. Fig. 1 zeigt die Bandlücke eines Halbleiters (z.B. Si, Ge, NaAs, CdTe, Diamant, SiC etc.), sowie das Grundniveau und das erste angeregte Niveau eines Donators. Es treten thermische Übergänge bzw. Übergänge durch Stoßionisation sowie Rekombination auf.

Wichtig für die Funktionsfähigkeit des Synistors ist die Bedingung, daß sehr viel mehr Elektronen durch Stoßionisation als durch thermische Anregung von den Donatorniveaus in das Leitungsband gehoben werden. Dies bedeutet, daß die Energielücke zwischen Donatorgrundzustand und Leitungsbandunterkante δ_{D} mindenstens 5 bis 10 mal größer als die thermische Anregungsenergie k_{B}T (k_{B} = Boltzmannkonstante = 1,38*10-²³J/K) sein muß.

Für Zimmertemperatur gilt: k_{B}T = 0.0259 eV. Damit kommen für den ungekühlten Betrieb von Synistoren nur tiefe Donatoren in Betracht. Einige mögliche Kombinationen sind in Tabelle 1 aufgelistet, wobei die Daten dem Buch von S.M.Sze, Physics of Semiconductor Devices, John Wiley & Sons, 1981 entnommen sind. Bei Verwendung von flachen Störstellen ist Kühlung bis teilweise zu 4,2 K notwendig. Dafür werden allerdings auch nur noch Betriebsspannungen von einigen mV benötigt. In jedem Fall sind niedrige Konzentrationen der Dotierstoffe gefordert (typisch: 10¹⁴ - 10¹⁶ Atome pro cm³) und Kompensationen von 0.4 bis 0.8.

**Tabelle 1:**

| Einige Halbleitermaterialien und günstige Dotiermaterialien zur Herstellung von Synistoren, die bei Zimmertemperatur betrieben werden können. | |
|---|---|
| Materialkombination | Energieabstand Donatorgrundniveau-Leitungsbandunterkante δ_{D} |
| Si/Se | 0.40 eV |
| Si/Ta | 0.43 eV |
| Si/Fe | 0.51 eV |
| Si/K | 0.35 eV |
| Ge/Se | 0.28 eV |
| Ge/Te | 0.30 eV |
| GaAs/0 | 0.67 eV |
| GaAs/Se | 0.53 eV |

Unter der Annahme, daß die Bedingung δ_{D} > 5 k_{B}T erfüllt ist, zeigt die Strom-Spannungs-Kennlinie eines solchermaßen dotierten Halbleiterelements einen S-förmigen Kurvenverlauf, der für die Ausprägung von Stromfilamenten typisch ist. D.h., das Halbleiterelement läßt sich in Bereiche unterteilen, in denen die Stromdichte j relativ groß ist und in Bereiche, in denen kein Stromfluß auftritt (j=0).

In Fig. 2 sind die geometrischen Abmessungen und die Ausprägung von Stromfilamenten schematisch dargestellt. Die Anzahl der Stromlinien symbolisiert ihre unterschiedliche Stärke.

Die Erfindung geht nun von der Erkenntnis aus, daß durch das Zuschalten eines Vorwiderstandes R zwischen den Stromfilamenten Konkurrenz auftritt und ein Verdrängungswettbewerb stattfindet, der nach synergetischen Gesetzen abläuft, d.h., die Verdrängungsdynamik kann durch ein synergetisches Potential beschrieben werden. Bezüglich des Begriffs synergetisches Potential wird auf das Buch von H. Haken "Synergetic Computers and Cognition, Springer Verlag, Berlin, 1991 verwiesen, auf das im übrigen bezüglich aller hier nicht im einzelnen erläuterten Begriff verwiesen wird. Am Ende des Verdrängungswettbewerbs fließt der gesamte Strom durch das anfänglich stärkere Stromfilament.

### Mit anderen Worten:

Der Synistor ist eine Hardware-Realisation des "the winner take it all" Konzeptes, das nicht nur beim synergetischen Computer, sondern auch in der Bildverarbeitung (z.B. Erosions-/Dilatationsfilter) und der Neuroelektronik eine wichtige Rolle spielt.

Um den Synistor zu Rechenzwecken einsetzen zu können, müssen gezielt Anfangszustände implementiert werden, die genau den Ordnungsparametern eines synergetischen Computers entsprechen, d.h. die Anzahl der Stromfilamente und ihre Stärke entsprechen der Anzahl der Ordnungsparameter und deren Größe. Dies kann elektronisch und optisch geschehen. Im elektronischen Fall würde an der Oberfläche des Synistors eine ortsunabhängige Spannungsverteilung U(x,y) angelegt, so daß sich durch Stoßionisation Stromfilamente verschiedener Stärke ausprägen. Im optischen Fall werden durch eine inhomogene Lichtverteilung, deren Wellenlänge einer Energie größer δ_{D} entspricht, lokal verschieden große Dichten von Leitungselektronen erzeugt, die wiederum zur Ausbildung verschieden starker Stromfilamente führen. Im elektronischen Fall hängt die Stärke des Filaments von der Größe der Spannung U_{sy} (x,y), im optischen Fall von der eingestrahlten Intensität ab. Inhomogene optische Lichtverteilungen lassen sich einfach mit oberflächenemittierenden Laserarrays erzeugen, die direkt an den Synistor gekoppelt werden. Für das Implementieren des Anfangszustandes reichen bereits kurze Laserimpulse aus. Natürlich können auch alle physikalischen Effekte zur Erzeugung der Eingangsspannungsverteilung U_{sy} (x,y) benutzt werden, die physikalischen Größen wie Druck (piezoelektrischer Effekt), Temperatur (thermoelektrischer Effekt) etc. in Spannung umwandeln, so daß ein Synistor direkt zur Weiterverarbeitung von z.B. taktilen Signalen eingesetzt werden kann. Die Verdrängungsdynamik läuft sehr schnell ab. Typische Zeitkonstanten sind ca. 50-100 ns.

Für die erreichbare Integration und damit auch für die Rechenleistung eines Synistors ist das Verhältnis zwischen der Dicke der Filamente und ihrer Wandstärke (d.h. der Bereich in denen die Stromdichte annähernd exponentiell abfällt) das entscheidende Kriterium. Als Faustregel kann gelten, daß Filamente deren Dicke kleiner als das 4-fache der Wandstärke beträgt, zusammenbrechen. Die Wandstärke ist durch die Debye-Länge L_{D} gegeben, wobei typische Werte für die L_{D} sich um 10 nm bewegen (hierzu wird auf das Buch von E. Schöll, Nonequilibrium Phase Transitions in Semiconductors, Springer Verlag, Berlin, 1987 verwiesen).

Folglich ergibt sich für die Mindestgröße eines Filamentes 60 nm (40 nm Dicke plus 2*10 nm Wandstärke) und falls man einen Abstand zum Nachbarn von 40 nm einrechnet, eine Integrationsdichte von 10¹⁰ Filamenten pro cm². Die derzeit mögliche Filamentgröße beträgt ca. 5 µm, so daß sich damit Integrationsdichten von ungefähr 10⁶ Filamanten/cm² erreichen lassen. Ein 1 cm²-großer Synistor kann also morphologische Operationen innerhalb eines Bildes mit 512 * 512 Pixeln in 0,1 µs durchführen. Das ist etwa einen Faktor 10⁵ schneller als bei gegenwärtiger Bildverarbeitungshardware.

Fig. 2 zeigt das Schema eines Synistors mit optischer Einkoppelung. Durch ein Laser- oder LED-Array wird eine lateral inhomogene Intensitätsverteilung in eine ca. 50 µm dicke Ta-dotierte Siliziumschicht eingekoppelt. Dazu ist es notwendig, daß die Kontaktschicht transmittierend ist. Weiterhin muß die Photonenenergie des eingestrahlten Lichtes größer als δ_{D} = 0.43 eV und kleiner als die Bandlücke von Silizium δ_{B} = 1.14 eV sein. Liegt die Betriebsspannung U oberhalb von 1V, so bildet sich eine inhomogene Stromfilamentverteilung aus, die in ihrer Stärke genau der Lichtverteilung entspricht. Durch Öffnen des Schalters S wird die Konkurrenz zugeschaltet, so daß nach etwa 50 bis 100 ns der gesamte Strom durch das anfänglich stärkste Stromfilament fließt. Folglich fällt nur noch an dem zugehörigen Ausgangswiderstand Spannung ab, was Aufschluß über das stärkste Eingangssignal liefert.

### Legende

- 1: Donator
- 2: erster angeregter Zustand
- 3: Grundniveau
- 4: Leitungsband
- 5: Valenzband
- 6: Bandlücke
- 7: Laser/LED-Array
- 8: Array-Ansteuerung
- 9: Isolationsschicht (transmittierend)
- 10: Ta-dotierte Si-Schicht 10-100 µm dick
- 11: Kontakte und Ausgangswiderstände
- 12: eingestrahltes Licht für Anfangs zustände
- 13: verschieden starke Stromfilamente
- 14: Kontaktschicht (transmittierend)

## Patentansprüche

1. Elektronisches Bauelement, mit
- N Eingangsanschlüssen die mit N Eingangssignalen beaufschlagbar sind,
- M Ausgangsanschlüssen, von denen jeder einem oder mehreren Eingangsanschlüssen zugeordnet ist, und
- einem Bauelement-Körper, in dem sich in Abhängigkeit von den Eingangssignalen Strompfade bzw. -filamente aufbauen, die die N Eingangsanschlüsse mit den Ausgangsanschlüssen verbinden,
dadurch **gekennzeichnet**, daß der elektronische Bauelemente körper aus einem Halbleitermaterial besteht, bei dem die Elekronenanregung in das Leitungsband vorwiegend durch Stoßionisation erfolgt und
dem ein Vorwiderstand vorschaltbar ist, der zur Realisierung einer Entscheidungs- bzw. Verdrängungsdynamik beiträgt, durch die eine an das Bauelement angelegte äußere Größe den Stromfluß durch den Bauelement-Körper zwischen einer anfänglichen Verteilung, bei der sich Strompfade mit Stromdichten (jᵢ) zwischen jedem Eingangsanschluß und dem zugeordneten Ausgangsanschluß ausgebildet haben und einer selbstorganisierenden Verteilung umschaltet, bei der Strom nur noch zwischen dem Eingangsanschluß, der mit dem Eingangssignal mit dem größten Wert beaufschlagt ist, und dem zugeordneten Ausgangsanschluß (-schlüssen) fließt.

2. Bauelement nach Anspruch 1,
dadurch **gekennzeichnet**, daß die an das Bauelement angelegte äußere Größe eine Betriebsspannung ist, die zur Einstellung direkt an den Bauelement-Körper und zur Einstellung der selbstorganisierten Verteilung über eine Schaltung, die einen geringeren Spannungsabfall über dem Bauelement bewirkt, z.B. einem regelbaren Vorwiderstand, angelegt wird.

3. Bauelement nach Anspruch 1 oder 2,
dadurch **gekennzeichnet,** daß die Eingangsanschlüsse auf der einen Seite des Bauelement-Körpers und die Ausgangsanschlüsse auf der anderen Seite des Bauelement-Körpers jeweils als Array angeordnet sind.

4. Bauelement nach Anspruch 1,
dadurch **gekennzeichnet,** daß das halbleitende Material mit Donatoren dotiert ist, bei denen die Energielücke δ_{D} zwischen Donator-Grundzustand und Leitungsbandunterkante wesentlich größer als die thermische Anregungsenergie k_{B}T (k_{B}: Boltzmannkontante) ist.

5. Bauelement nach Anspruch 4,
dadurch **gekennzeichnet,** daß die Energielücke δ_{D} wenigstens um den Faktor 5 größer als die thermische Anregungsenergie k_{B}T ist.

6. Bauelement nach einem der Ansprüche 4 bis 5,
dadurch **gekennzeichnet,** daß für ein bei Raumtemperatur betriebenes Bauelement als halbleitendes Material silizium und als Donator-Material Se, Ta, K oder Fe eingesetzt wird.

7. Bauelement nach einem der Ansprüche 4 bis 5,
dadurch **gekennzeichnet,** daß für ein bei Raumtemperatur betriebenes Bauelement als halbleitendes Material Germanium und als Donator-Material Se, oder Te eingesetzt wird.

8. Bauelement nach einem der Ansprüche 4 bis 5,
dadurch **gekennzeichnet**, daß für ein bei Raumtemperatur betriebenes Bauelement als halbleitendes Material GaAs und als Donator-Material Se, Ta oder Fe eingesetzt wird.

9. Bauelement nach einem der Ansprüche 1 bis 8,
dadurch **gekennzeichnet,** daß die N Eingangssignale als Eingangsspannungen an die Eingangsanschlüsse angelegt werden.

10. Bauelement nach einem der Ansprüche 4 bis 9,
dadurch **gekennzeichnet**, daß die Eingangssignale an eine LED- oder Laserdioden-Array angelegt werden, das den Halbleiterkörper mit einer inhomogenen Lichtverteilung entsprechend den Eingangssignalen bestrahlt, und deren Photonenenergie größer als die Energielücke δ_{D} ist.

11. Rechenschaltung, bei der ein Vorverarbeitungsmodul aus den von einem Aufnahme-Sensorarray bereitgestellten Sensorsignalen Ordnungsparamter generiert, die ein nach dem synergetischen Prinzip arbeitender Schaltkreis auswertet, dadurch **gekennzeichnet,** daß der Schaltkreis ein Bauelement nach einem der Ansprüche 1 bis 10 ist.

12. Rechenschaltung nach Anspruch 11,
dadurch **gekennzeichnet,** daß das Sensorarray ein Photodiodenarray oder ein Array mit druck- oder temperaturempfindlichen Elementen ist.

13. Rechenschaltung nach Anspruch 11 oder 12,
dadurch **gekennzeichnet,** daß das Vorverarbeitungsmodul zwei Module aufweist, von denen das erste die Eingangssignale translations-, rotations- und skalierungsinvariant macht, und das zweite durch Vergleich mit Prototypenbildern die Ordnungsparameter generiert.

## Claims

1. Electronic component having
- N input terminals adapted for application of N input signals,
- M output terminals whereof each is associated with one or several input terminals, and
- a component body in which current paths or current filaments, respectively, are established in response to said input signals, which connect said N input terminals to said M output terminals,
**characterized** in that said electronic component body consists of a semiconductor material in which the electrons are excited to the conduction band predominantly by collision ionization, and
to which a series resistor may be connected which contributes to the implemention of a dynamic decision or displacement system employed by an external quantity applied to the component so as to switch the current flow through said component body between an initial distribution, at which current paths with current densities (*j*ᵢ) are formed between each input terminal and the associated output terminal, and a self-organizing distribution at which the current flows only between the input terminal to which the input signal of the greatest value is applied and the associated output terminal(s).

2. Component according to Claim 1,
**characterized** in that said external quantity applied to the component is an operating voltage which is applied directly to said component body for setting and which is applied via a circuit which induces a smaller voltage drop across the component, e.g. via a variable series resistor, for setting said self-organizing distribution.

3. Component according to Claim 1 or 2,
**characterized** in that said input terminals are disposed on one side of said component body, and said output terminals are disposed on the other side of said component body, in each case as an array.

4. Component according to Claim 1,
**characterized** in that said semiconductor material is doped with donators in which the energy gap δ_{D} between the donator ground state and the lower conduction band edge is substantially greater than the thermal excitation energy k_{B}T (k_{B}: Boltzmann's constant).

5. Component according to Claim 4,
**characterized** in that said energy gap δ_{D} is at least greater than the thermal excitation energy k_{B}T by a factor of 5.

6. Component according to any of Claims 4 to 5,
**characterized** in that silicon is utilized as semiconductor material, and Se, Ta, K, or Fe is employed as donator material so as to form a component operable at room temperature.

7. Component according to any of Claims 4 to 5,
**characterized** in that Germanium is utilized as semiconductor material, and Se or Te is employed as donator material so as to form a component operable at room temperature.

8. Component according to any of Claims 4 to 5,
**characterized** in that GaAs is utilized as semiconductor material, and Se, Ta, or Fe is employed as donator material so as to form a component operable at room temperature.

9. Component according to any of Claims 1 to 8,
**characterized** in that said N input signals are applied as input voltages to said input terminals.

10. Component according to any of Claims 4 to 9,
**characterized** in that said input signals are applied to a LED or laser diode array which irradiates the semiconductor body with an inhomogeneous light distribution corresponding to said input signals, and having a photon energy which is greater than said energy gap δ_{D}.

11. Computing circuit in which a pre-processing module generates order parameters by deriving them from the sensor signals provided by a receiving sensor array, which order parameters are evaluated by a circuit operating on the synergetic principle,
**characterized** in that the circuit is a component according to any of Claims 1 to 10.

12. Computing circuit according to Claim 11,
**characterized** in that said sensor array is a photodiode array or an array including pressure-sensitive or temperature-responsive elements.

13. Computing circuit according to Claim 11 or 12,
**characterized** in that said pre-processing module comprises two modules whereof the first one renders said input signals invariant in terms of translation, rotation and scaling, and whereof the second one generates said order parameters by a comparison against prototype images.

## Revendications

1. Composant électronique, avec
- des connexions d'entrée N qui peuvent être alimentées par des signaux d'entrée N,
- des connexions de sortie M dont chacune est affectée à une ou à plusieurs connexions d'entrée, et
- un corps de composant, dans lequel sont constitués des filaments ou voies de courant en fonction des signaux d'entrée, qui relient les connexions d'entrée N avec les connexions de sortie M,
caractérisé en ce que le corps du composant électronique est constitué par un matériau semi-conducteur dans lequel l'excitation dans la bande de conduction s'effectue de façon prédominante par ionisation par impact, et
auquel une prérésistance peut être montée en amont et contribuer à la réalisation d'une dynamique de décision ou de rejet, par laquelle une variable extérieure appliquée au composant commute le flux de courant à travers le corps du composant entre une répartition initiale dans laquelle ont été formées des voies de courant avec des densités (jᵢ) entre chaque connexion d'entrée et la connexion de sortie affectée et une répartition auto-organisée, dans laquelle le courant ne s'écoule plus qu'entre la connexion d'entrée qui est alimentée par le signal d'entrée de la plus grande valeur, et s'écoule à ou aux connexions de sortie affectée(s).

2. Composant électronique selon la revendication 1,
caractérisé en ce que la valeur extérieure appliquée au composant est une tension de service qui est appliquée pour la régulation directement sur le corps du composant et pour la régulation de la répartition auto-organisée par l'intermédiaire d'un circuit qui entraîne une très faible chute de tension au-dessus du composant, par exemple une prérésistance réglable.

3. Composant électronique selon la revendication 1 ou 2,
caractérisé en ce que les connexions d'entrée sur un côté du corps du composant électronique et les connexions de sortie sur l'autre côté du corps du composant électronique sont respectivement agencés en array ou matrice.

4. Composant électronique selon la revendication 1,
caractérisé en ce que le matériau semi-conducteur est doté de donateurs dans lesquels l'absence d'énergie δ_{D} entre l'état de base du donateur et le bord inférieur de la bande de conduction est sensiblement supérieure à l'énergie d'excitation thermique k_{B}T (k_{B} : constante de Boltzmann).

5. Composant électronique selon la revendication 4,
caractérisé en ce que l'absence d'énergie δ_{D} est au moins supérieure d'un facteur 5 à l'énergie d'excitation thermique k_{B}T.

6. Composant électronique selon l'une des revendications 4 à 5,
caractérisé en ce que pour un composant électronique fonctionnant à la température ambiante comme matériau semi-conducteur, on pourra utiliser du silicium et en tant que matériau donateur du Se, Ta, K ou Fe.

7. Composant électronique selon l'une des revendications 4 à 5,
caractérisé en ce que pour un composant électronique fonctionnant à température ambiante comme matériau semi-conducteur, on pourra utiliser du germanium et comme matériau donateur du Se ou du Te.

8. Composant électronique selon l'une des revendications 4 à 5,
caractérisé en ce que pour un composant électronique fonctionnant à température ambiante, on pourra utiliser en tant que matériau semi-conducteur du GaAs et comme matériau donateur du Se, Ta ou Fe.

9. Composant électronique selon l'une des revendications 1 à 8,
caractérisé en ce que les signaux d'entrée N sont appliqués en tant que tensions d'entrée sur les connexions d'entrée.

10. Composant électronique selon l'une des revendications 4 à 9,
caractérisé en ce que les signaux d'entrée sont appliqués sur un array LED ou à diodes laser qui irradie le corps à semiconducteurs avec une répartition lumineuse non homogène correspondant aux signaux d'entrée et dont la photoénergie est supérieure à l'absence d'énergie δ_{D}.

11. Circuit de calcul dans lequel un module de prétraitement est généré à partir de paramètres d'ordre, signaux de capteur préparés par une matrice ou agencement de capteurs de réception qui évalue un circuit de communication fonctionnant selon le principe de la synergie, caractérisé en ce que le circuit de commande est un composant électronique selon l'une des revendications 1 à 10.

12. Circuit de calcul selon la revendication 11,
caractérisé en ce que la matrice de capteurs est un agencement de photodiodes ou un agencement avec des éléments sensibles à la pression ou à la température.

13. Circuit de calcul selon la revendication 11 ou 12,
caractérisé en ce que le module de prétraitement comporte deux modules dont le premier effectue les signaux d'entrée invariant en translation, rotation et cadrage, et le deuxième module génère les paramètres d'ordre par comparaison avec des images phototypes.
